(19) Europäisches Patentamt
European Patent Office
Office européen des brevets

(11) **EP 4 293 704 A1**

(12) **EUROPEAN PATENT APPLICATION**

(43) Date of publication:
**20.12.2023 Bulletin 2023/51**

(21) Application number: **23174747.8**

(22) Date of filing: **23.05.2023**

(51) International Patent Classification (IPC):
**H01J 49/48** (2006.01)   **H01J 49/02** (2006.01)
**H01J 49/00** (2006.01)   **H01J 37/244** (2006.01)
**G01N 23/2273** (2018.01)   **G01N 23/2276** (2018.01)

(52) Cooperative Patent Classification (CPC):
**H01J 49/484; G01N 23/2273; G01N 23/2276;**
**H01J 37/244; H01J 49/0027; H01J 49/025;**
H01J 2237/2522

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **16.06.2022 JP 2022097319**

(71) Applicant: **Jeol Ltd.
Akishima-shi, Tokyo 196-8558 (JP)**

(72) Inventors:
• **UCHIDA, Tatsuya
Akishima, 196-8558 (JP)**
• **SHIMOJIMA, Terutaka
Akishima, 196-8558 (JP)**

(74) Representative: **Boult Wade Tennant LLP
Salisbury Square House
8 Salisbury Square
London EC4Y 8AP (GB)**

(54) **ELECTRON SPECTROMETER AND ANALYTICAL METHOD**

(57)     An electron spectrometer is provided which can collect spectra in a reduced measurement time. The electron spectrometer (100) includes an electron analyzer (30) for providing energy dispersion of electrons emitted from a sample (S), a detector (40) having a plurality of detection elements juxtaposed and arranged in the direction of energy dispersion of the dispersed electrons, and a processor (60). The processor (60) operates (i) to sweep a measurement energy in first incremental energy steps ($\Delta E_1$) within the analyzer, to detect the dispersed electrons with the detection elements, and to obtain a plurality of resulting first spectra; (ii) to interpolate points of measurement in each of the first spectra; and (iii) to generate a spectral chart in second incremental energy steps ($\Delta E_2$) smaller than the first incremental energy steps ($\Delta E_1$) on the basis of the first spectra for which the points of measurement have been interpolated.

**EP 4 293 704 A1**

START

SET MEASUREMENT CONDITIONS
(INCREMENTAL ENERGY STEP DE₁) — S100

ACQUIRE PLURAL SPECTRA — S102

SET INCREMENTAL ENERGY STEP DE₂ — S104

INTERPOLATE POINTS OF MEASUREMENT FOR
PLURAL SPECTRA — S106

ACCUMULATE PLURAL SPECTRA INTO ONE
MULTISPECTRAL CHART — S108

END

FIG. 17

**Description**

BACKGROUND OF THE INVENTION

1. Field of the Invention

The present invention relates to an electron spectrometer and an analytical method.

2. Description of the Related Art

In electron spectrometers such as X-ray photoelectron spectrometers and Auger electron spectrometers, only electrons having energies in a certain energy range can be detected by providing energy dispersion of electrons with an electron analyzer. The energy range for detection can be selected by controlling electron lenses equipped in the analyzer. An energy spectrum can be collected by repeating a measurement while sweeping the measurement energy.

Patent document 1 discloses a detector mounted in an electron spectrometer, the detector having channeltrons arrayed in the direction of energy dispersion of electrons which are dispersed in energy by an electron analyzer. In this electron spectrometer, when a spectrum is collected, electrons dispersed in energy with the analyzer are, in general, detected with a certain one of the channeltrons.

Citation List

Patent Documents

Patent Document 1: JP-A-2001-312994

Where electrons are detected with a certain one channeltron as described above, in order to collect a spectrum, the measurement must be carried out repetitively while sweeping the measurement energy and so it takes a long time to collect a spectrum.

SUMMARY OF THE INVENTION

One aspect of the electron spectrometer associated with the present invention comprises: an electron analyzer for providing energy dispersion of electrons emitted from a sample; a detector having a plurality of detection elements juxtaposed and arranged in the direction of energy dispersion of the electrons which have been dispersed in energy by the analyzer; and a processor. The processor operates (i) to sweep a measurement energy in first incremental energy steps within the analyzer, to cause the electrons dispersed in energy by the analyzer to be detected by the plurality of detection elements, and to obtain a plurality of resulting first spectra, (ii) to interpolate points of measurement in each of the plurality of first spectra; and (iii) to generate a spectral chart in second incremental energy steps smaller than the first incremental energy steps on the basis of the plurality of first spectra for which the points of measurement have been interpolated.

With this electron spectrometer, the number of measurements can be reduced, for example, as compared to the case where electrons are detected with a certain one detection element. Therefore, with this electron spectrometer, the measurement time taken to collect a spectrum can be shortened.

One aspect of the analytical method associated with the present invention uses an electron spectrometer which includes both an electron analyzer for providing energy dispersion of electrons emitted from a sample and a detector having a plurality of detection elements juxtaposed and arranged in the direction of energy dispersion of the electrons dispersed in energy by the analyzer. The analytical method comprises the steps of: sweeping a measurement energy in first incremental energy steps within the analyzer so that electrons are dispersed in energy within the analyzer, detecting the dispersed electrons with the plurality of detection elements, and obtaining a plurality of resulting first spectra; interpolating points of measurement in each of the plurality of first spectra; and generating a spectral chart in second incremental energy steps smaller than the first incremental energy steps on the basis of the plurality of first spectra for which the points of measurement have been interpolated.

In this analytical method, the number of measurements can be reduced, for example, as compared to the case where electrons are detected with a certain one detection element. Therefore, in this analytical method, the measurement time taken to collect a spectrum can be shortened.

BRIEF DESCRIPTION OF THE DRAWINGS

FIG. 1 is a diagram showing the configuration of an electron spectrometer associated with one embodiment of the present invention.

FIG. 2 is a schematic diagram of a detector.

FIG. 3 is a diagram illustrating the function of the detector.

FIG. 4 is a graph illustrating the relationship between incremental energy step $\Delta E_1$ and energy resolution.

FIG. 5 is a graph illustrating measurement energies for respective ones of 7 channeltrons for one case.

FIG. 6 is a graph illustrating measurement energies for respective ones of the 7 channeltrons for another case.

FIG. 7 is a graph representing the equality, $\Delta E_1 = f(E_m)$, where $f(E_m) = \alpha E_m$.

FIG. 8 is a graph representing the equality, $\Delta E_1 = f(E_m)$, where $f(E_m) = \max(\alpha E_m, \beta)$.

FIG. 9 is a table of $\beta$ and d.

FIG. 10 is a diagram showing measurement energies for respective ones of channeltrons of the detector.

FIG. 11 is a chart showing 7 spectra.

FIG. 12 is a chart similar to FIG. 11 but illustrating processing for interpolating points of measurement in each of the 7 spectra.

FIG. 13 is a chart similar to FIGS. 11 and 12 but illustrating the results of an operation for accumulating the 7 spectra for which the points of measurement have been linearly interpolated.

FIG. 14 is a chart illustrating a case where the measurement energies for the respective spectra are not coincident.

FIG. 15 is a chart illustrating a case where the measurement energies for the respective spectra are coincident.

FIG. 16 is a chart illustrating the SN ratios at actually measured points and the SN ratios at interpolated points of measurement.

FIG. 17 is a flowchart illustrating a processing sequence performed by a processor.

FIG. 18 is a graph indicating a calculated noise level when the magnitude of each incremental measurement step is M times as large as that of each incremental differential step.

FIG. 19 is a graph of noise component $D_{\sigma m}$ normalized with a measurement time under the condition M = 1.

FIG. 20 is a graph of noise component $D_{\sigma m}$ normalized with a measurement time under the condition M = 1.

FIG. 21 is a graph comparing a case where the energy shift occurring during differential is zero and a case where the energy shift occurring during differential is $(1/2) \cdot \Delta E$.

FIG. 22 is a graph showing the result of averaging of noise component $D_{\sigma m}$.

FIG. 23 is a graph showing a resolution function.

FIG. 24 is a chart representing a resolution function when incremental measurement steps are varied.

FIG. 25 is a graph showing the result of an operation consisting of differentiating, at seven points, the resolution function when the incremental measurement steps are varied.

FIG. 26 is a graph showing the resolution function when the measurement starting energy is deviated by +2 eV and its differential results.

FIG. 27 is a graph showing the resolution function when the measurement starting energy is deviated by +4 eV and its differential results.

FIG. 28 is a graph showing the resolution function when the measurement starting energy is deviated by +6 eV and its differential results.

FIG. 29 is a graph showing the result obtained by accumulating the 7 spectra.

DETAILED DESCRIPTION OF THE INVENTION

The preferred embodiments of the present invention are hereinafter described in detail with reference to the accompanying drawings. Note that embodiments given below are not intended to unduly restrict the contents of the present invention set forth in the claims and that all the configurations described below are not always constituent components of the present invention.

In the following description, an Auger electron spectrometer is taken as one example of the electron spectrometer associated with the present invention. It is to be noted that the electron spectrometer associated with the present invention is not restricted to such an apparatus. For example, the electron spectrometer associated with the present invention may also be an X-ray photoelectron spectrometer.

1. Electron Spectrometer

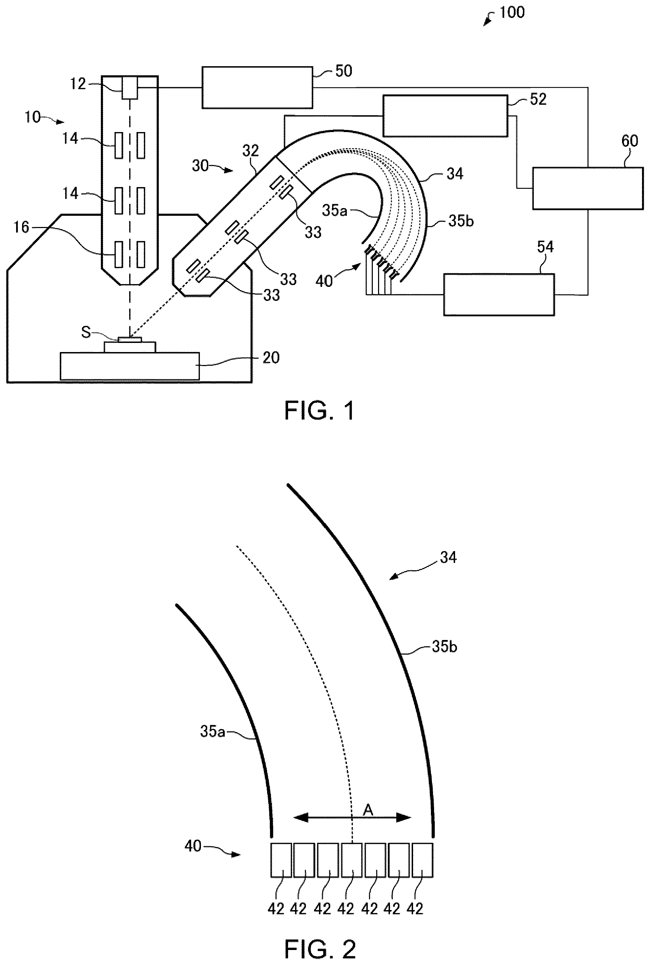

An electron spectrometer associated with one embodiment of the present invention is first described by referring to FIG. 1, which shows the configuration of the electron spectrometer, 100. The electron spectrometer 100 is an apparatus for analyzing a sample by Auger electron spectroscopy which is a technique for performing elemental analysis by measuring the energies of Auger electrons emitted from a sample that is excited by an electron beam or other means.

As shown in FIG. 1, the electron spectrometer 100 includes an electron beam source 10 for generating an electron beam, a sample stage 20, an electron analyzer 30, a detector 40, an illumination controller 50, an analyzer controller 52, a counter-computer 54, and a processor 60.

The electron beam source 10 operates to direct the electron beam at a sample S and includes an electron gun 12, electron lenses 14, and a beam deflector 16. The electron gun 12 emits the electron beam. The electron lenses 14 focus the electron beam emitted from the electron gun 12. The electron beam focused by the electron lenses 14 is deflected by the beam deflector 16 which permits the electron beam to impinge at any desired position on or in the sample S. Also, the deflector 16 enables the sample S to be scanned by the electron beam.

The sample stage 20 can hold and move the sample S. The sample stage 20 may be equipped, for example, with a goniometer for tilting the sample S, and permits the sample S to be placed in position.

The electron analyzer 30 provides energy dispersion of Auger electrons emitted from the sample S in response to the illumination with the beam. The electron analyzer 30 includes an input lens assembly 32 and an electrostatic hemispherical analyzer 34. The input lens assembly 32 collects and passes the incident electrons into the electrostatic hemispherical analyzer 34. The input lens assembly 32 decelerates electrons to thereby provide variable energy resolution. The input lens assembly 32 is made up of a plurality of electrostatic lenses 33, for example.

The electrostatic hemispherical analyzer 34 has an inner hemispherical electrode 35a and an outer hemispherical electrode 35b. In the hemispherical analyzer 34, a voltage is applied between the inner hemispherical electrode 35a and the outer hemispherical electrode 35b and thus electrons in an energy range corresponding to the applied voltage can be extracted.

The detector 40 detects electrons which have been dispersed in energy by the electron analyzer 30. FIG. 2 schematically shows the detector 40 which has a plurality of channeltrons 42 each of which is an example of a detection element. In the example of FIG. 2, the detector 40 has seven channeltrons 42. There are no restrictions on the number of channeltrons 42 as long as the number is two or more. Each channeltron 42 is a detector for detecting electrons and producing an amplified output signal.

The seven channeltrons 42 are arrayed in the direction of energy dispersion A at the exit plane of the electrostatic hemispherical analyzer 34, i.e., at the plane of energy dispersion. Therefore, the 7 channeltrons 42 can detect electrons of different energies. Consequently, the detector 40 can detect electrons of different energies at the same time.

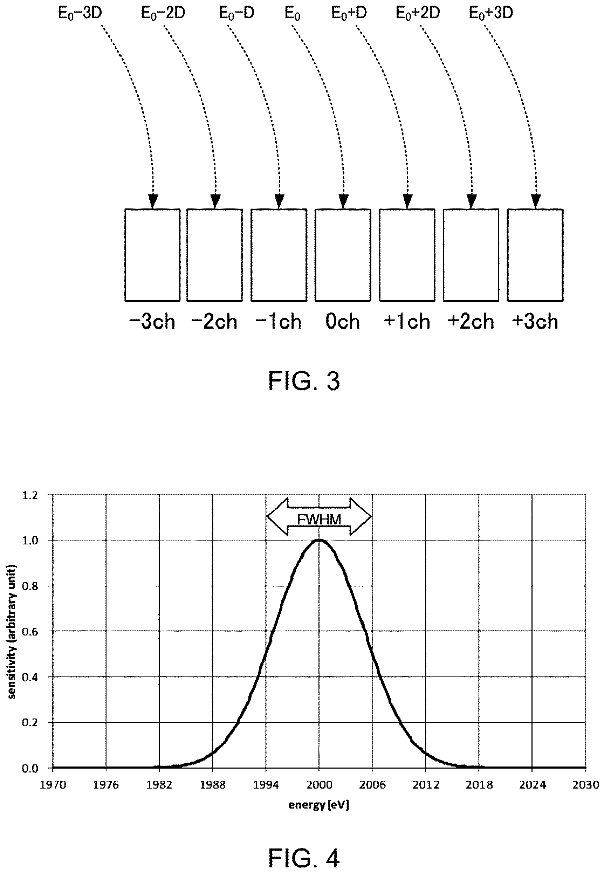

FIG. 3 illustrates the function of the detector 40. As shown, channel numbers -3ch to +3ch are respectively assigned to the seven channeltrons 42. In particular, the channeltron 42 of 0 channel detects electrons passing through the midpoint between the inner hemispherical electrode 35a and the outer hemispherical electrode 35b of the electrostatic hemispherical analyzer 34. The channeltrons 42 of -1 ch, -2 ch, and -3 ch are arranged in turn from the channeltron 42 of 0 ch towards the inner hemispherical electrode 35a. Also, the channeltrons 42 of +1 ch, +2 ch, and +3 ch are arranged in turn from the channeltron 42 of 0 ch towards the outer hemispherical electrode 35b.

The 7 channeltrons 42 are so arranged that the differences in measurement energy between any adjacent two of the channels are all equal to D. Therefore, if the measurement energy of the channeltron 42 of the 0 ch is set to $E_0$, for example, the measurement energy of the channeltron of -3 ch is $E_0$ - 3D. The measurement energy of the channeltron of -2 ch is $E_0$ - 2D. The measurement energy of the channeltron of -1 ch is $E_0$ - D. The measurement energy of the channeltron of +1 ch is $E_0$ + D. The measurement energy of the channeltron of +2 ch is $E_0$ + 2D. The measurement energy of the channeltron of +3 ch is $E_0$ + 3D.

In the foregoing description, the detector 40 consists of the seven channeltrons 42. The configuration of the detector 40 is not restricted to this structure. For example, a microchannel plate detector, a multianode detector, a CMOS camera, or the like may be used as the detector 40, in which case a plurality of pixels are treated together as one pixel such that as if there were a desired number of channels.

The illumination controller 50 controls the electron beam source 10, for example, based on a control signal from the processor 60 such that the electron beam impinges at a given position on the sample S.

The analyzer controller 52 controls the electron analyzer 30. In particular, the analyzer controller 52 controls the deceleration rate of electrons at the input lens assembly 32 and the voltage applied between the inner hemispherical electrode 35a and the outer hemispherical electrode 35b on the basis of control signals from the processor 60.

The counter-computer 54 counts the electrons detected by the channeltrons 42 and sends the counts of the detected electrons to the processor 60. The processor 60 acquires information about the counts of the electrons in the channeltrons 42. Therefore, the processor 60 can obtain an energy spectrum (which may hereinafter be simply referred to as a spectrum) for each channeltron 42. That is, the processor 60 can simultaneously obtain a plurality of spectra corresponding in number to the channeltrons 42.

The processor 60 performs an operation for creating Auger spectra and operations for controlling the illumination controller 50 and the analyzer controller 52 based on the output from the detector 40 which is sent from the counter-computer 54 and which represents the results of the detection. The processing performed by the processor 60 is described in detail later.

The processor 60 includes processing circuitry (such as a CPU (central processing unit) and an FPGA (Field Programmable Gate Array)) and memory circuits (such as semiconductor memories). The processor 60 performs various types of calculational operations and various types of control operations by executing programs stored in the memory circuits by means of the processing circuitry.

2. Collection of Spectra

2.1. Specification of Energy Resolution

The electron spectrometer 100 can collect energy spectra by repeating a measurement while sweeping the measurement energy with the electron analyzer 30. A method of implementing the collection of spectra in the electron spectrometer 100 is described below.

First, the user sets measurement conditions by manipulating the setting portion of the electron spectrometer 100 (such as a user interface). The processor 60 accepts the set measurement conditions which are reflected in the processing of the processor 60.

The measurement conditions include selection of measurement mode, starting energy, ending energy, and energy resolution. A measurement mode is selected from a CAE (constant analyzer energy) mode and a CRR (constant retarding ratio) mode. The measurement mode will be described in detail later. The starting energy gives a measurement energy at which a measurement is started. The ending energy gives a measurement energy at which the measurement is ended. That is, a measurement can produce a spectrum of energies in the range from the starting energy to the ending energy. An energy resolution is a spectral resolution and given, for example, by a half value width (full width at half maximum (FWHM)) peak appearing in a spectrum. For example, in the case of an elemental analysis to identify the elemental composition of a sample, the energy resolution is set lower. In the case of a chemical state analysis, the energy resolution is set higher.

2.2. Setting of Incremental Energy Step $\Delta E_1$ in Measurement

The processor 60 sets the incremental energy step $\Delta E_1$ in a measurement, based on the energy resolution. The electron spectrometer 100 performs a measurement while sweeping the measurement energy in incremental energy steps of $\Delta E_1$. For example, in the example shown in FIG. 3, if the measurement energy of 0 ch is $E_0$ in the first measurement, then the measurement energy of 0 ch is $E_0 + \Delta E_1$ in the second measurement. The measurement energy of 0 ch is $E_0 + 2\Delta E_1$ in the third measurement. Accordingly, the interval between the measurement points in a spectrum obtained from the channeltrons 42 is the incremental energy step $\Delta E_1$.

FIG. 4 is a graph illustrating the relationship between the incremental energy step $\Delta E_1$ and the energy resolution. The energy resolution can be represented, for example, by full width at half maximum (FWHM). In the graph of FIG. 4, the energy resolution in the vicinity of 2,000 eV is FWHM = 12 eV. If the incremental energy step $\Delta E_1$ is sufficiently small compared with the waveform of FIG. 4 having a maximum value of 1.0, then a waveform having a maximum value of 1.0 is obtained as a result of a measurement. However, if the incremental energy step $\Delta E_1$ is 6 eV, for example, then it is not assured that a waveform having a maximum value of 1.0 is obtained as a result of a measurement. For example, where the incremental energy step $\Delta E_1$ is 6 eV, it is assumed that the following two patterns are produced as the measurement energy.

pattern 1: 1970, 1976, 1982, 1988, 1994, 2000, 2006, 2012, 2018, 2024, 2030
pattern 2: 1973, 1979, 1985, 1991, 1997, 2003, 2009, 2015, 2021, 2027, 2033

In the case of pattern 1, a waveform having a maximum value of 1.0 and FWHM = 12 eV is obtained as a result of a measurement. In the case of pattern 2, a waveform having a maximum value of 0.8 and FWHM = 12 eV is obtained as a result of a measurement. With respect to points not measured, their maximum values and FWHM have been obtained by linear interpolation.

In this way, if the incremental energy steps of $\Delta E_1$ remain the same, the degree of distortion of spectrum varies according to the relationship between the measurement energy and the peak position. As described above, if the incremental energy step $\Delta E_1$ is half of the FWHM, the maximum value varies by as much as 20% and so the incremental energy step $\Delta E_1$ must be reduced.

The difference D in measurement energy between channels is in proportion to the energy resolution and, therefore, calculating the incremental energy step $\Delta E_1$ from the energy resolution is essentially identical to calculating the incremental energy step $\Delta E_1$ from the difference D in measurement energy between channels. Accordingly, the latter case is described hereinafter.

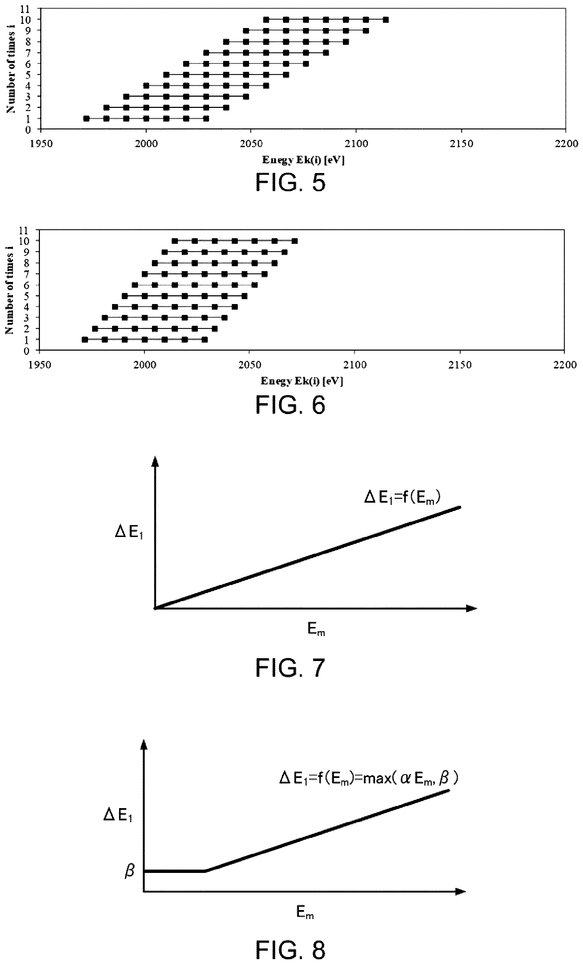

FIGS. 5 and 6 are graphs showing the measurement energies for respective ones of the seven channeltrons. In these two figures, -3 ch, -2 ch, -1 ch, 0 ch, +1 ch, +2 ch, and +3 ch are arranged in order from the lower energy side to the higher energy side.

FIG. 5 shows a case where the incremental energy step $\Delta E_1$ is equal to the difference D in measurement energy between channels ($\Delta E_1$ = D). FIG. 6 shows a case where the incremental energy step $\Delta E_1$ is half of the difference D in measurement energy between channels ($\Delta E_1$ = D/2).

Using the difference D in measurement energy between channels, the incremental energy step $\Delta E_1$ is given by

$$\Delta E_1 = \max\ (\beta,\ \alpha \cdot c \cdot (E_p + \gamma \cdot E_m))$$

$$\alpha = d \cdot (1 + 0.5 \cdot d \cdot c \cdot \gamma)$$

$\beta$: lower limit of incremental energy step $\Delta E_1$

$\alpha$: proportional coefficient of incremental energy step $\Delta E_1$

$c \cdot (E_p + \gamma \cdot E_m)$: difference D in measurement energy between channels

c: ratio between the energy of electrons passing through the electron analyzer and the difference D in measurement energy between channels

$E_p$: pass energy (energy of electrons passing through the electron analyzer) in the CAE mode

$\gamma$: attenuation rate of the input lens assembly in the CRR mode

$E_m$: measurement energy

d: ratio between the difference D in measurement energy between channels and the incremental energy step $\Delta E_1$

$\gamma$ is the attenuation rate of the input lens assembly in the CRR mode. For example, in a case where the energy of electrons which have passed through the input lens assembly decreases to a half (1/2), $\gamma$= 1/2. Where $\Delta E_1$ = D as shown in FIG. 5, the ratio d is unity (d = 1). In the case of FIG. 6 where $\Delta E_1$ = D/2, the ratio d = 1/2.

The electron spectrometer 100 can perform measurements either in the CAE mode or in the CRR mode. In the CAE mode, the energy assumed by electrons in passing through the electron analyzer 30, i.e., the pass energy, is constant irrespective of the energies of electrons emitted from the sample S. In the CAE mode, the voltage applied to the input lens assembly 32 is swept while maintaining constant the potential difference applied between the inner hemispherical electrode 35a and the outer hemispherical electrode 35b. In the CAE mode, the energy resolution is constant over the whole range of measurement energy.

In contrast, in the CRR mode, electrons are decelerated at a constant rate according to the kinetic energy of electrons to be measured. In the CRR mode, the potential difference applied between the inner hemispherical electrode 35a and the outer hemispherical electrode 35b is swept along with the voltage applied to the input lens assembly 32, and electrons are dispersed in energy at a given deceleration rate. In the CRR mode, the energy resolution is in proportion to the measurement energy.

In the CAE mode, $\gamma$ = 0. Accordingly, in the CAE mode, the incremental energy step $\Delta E_1$ is given by

$$\Delta E_1 = \max\ (\beta,\ \alpha \cdot c \cdot E_p) \tag{1}$$

$$\alpha = d$$

In the CAE mode, the lower limit $\beta$ is an eigen value and the product of $\alpha \cdot c \cdot E_p$ is also an eigen value. Consequently, the incremental energy step $\Delta E_1$ is fixed.

In the CRR mode, $E_p$ = 0 and, therefore, in the CRR mode, the incremental energy step $\Delta E_1$ is given by

$$\Delta E_1 = \max\ (\beta,\ \alpha \cdot c \cdot \gamma \cdot E_m) \tag{2}$$

$$\alpha = d \cdot (\ 1 + 0.5 \cdot d \cdot c \cdot \gamma\ )$$

In the CRR mode, the lower limit $\beta$ is an eigen value, while the product of $\alpha \cdot c \cdot \gamma \cdot E_m$ is in proportion to the measurement energy. Therefore, the incremental energy step $\Delta E_1$ is given by

$$\Delta E_1 = f\ (E_m) \tag{3}$$

$$f(E_m) = \max(\alpha\, E_m, \beta) \qquad\qquad (4)$$

where the proportional coefficient $\alpha$ of Eq. (4) is $\alpha = \alpha \cdot c \cdot \gamma$. The proportional coefficient $\alpha$ in the right side of this equation is $\alpha$ in Eq. (2).

FIG. 7 is a graph showing the equality, $\Delta E_1 = f(E_m)$, where $f(E_m) = \alpha\, E_m$. FIG. 8 is a graph showing the equality, $\Delta E_1 = f(E_m)$, where $f(E_m) = \max(\alpha\, E_m, \beta)$.

As shown in FIG. 7, where it is assumed that $f(E_m) = \alpha\, E_m$, i.e., the incremental energy step $\Delta E_1$ is the product of $\alpha$ and $E_m$, as the measurement energy $E_m$ is reduced, the incremental energy step $\Delta E_1$ decreases and vice versa. Accordingly, when the measurement energy $E_m$ has a value close to zero, the incremental energy step $\Delta E_1$ is infinitesimal.

Accordingly, as shown in FIG. 8, it is assumed that $f(E_m) = \max(\alpha\, E_m, \beta)$. The incremental energy step $\Delta E_1$ is the product of $\alpha$ and $E_m$. If the product of $\alpha$ and $E_m$ is smaller than the lower limit $\beta$, then it is assumed that $\Delta E_1 = \beta$. Consequently, it is possible to solve the problem that the incremental energy step $\Delta E_1$ is quite small when the measurement energy $E_m$ assumes a value close to zero.

In the CRR mode, there is a proportional relationship between the measurement energy $E_m$ and the energy resolution. Therefore, there is also a proportional relationship between the measurement energy $E_m$ and the difference D in measurement energy between channels. Accordingly, when the ratio d is set, the proportional coefficient $\alpha$ is computed using the correction term $(1 + 0.5 \cdot d \cdot c \cdot \gamma)$ of the difference D in measurement energy between channels.

2.3. Table for Calculation of $\Delta E_1$

In the above equation indicating the incremental energy step ($\Delta E_1$) above, c, $E_p$, $\gamma$, and $E_m$ have predetermined values. On the other hand, with respect to $\beta$, $\alpha$, and d, their values must be set. Of these parameters, the proportional coefficient $\alpha$ can be calculated from the formula $\alpha = d \cdot (1 + 0.5 \cdot d \cdot c \cdot \gamma)$ and so parameters which should be determined in order to calculate the incremental energy step $\Delta E_1$ are $\beta$ and d.

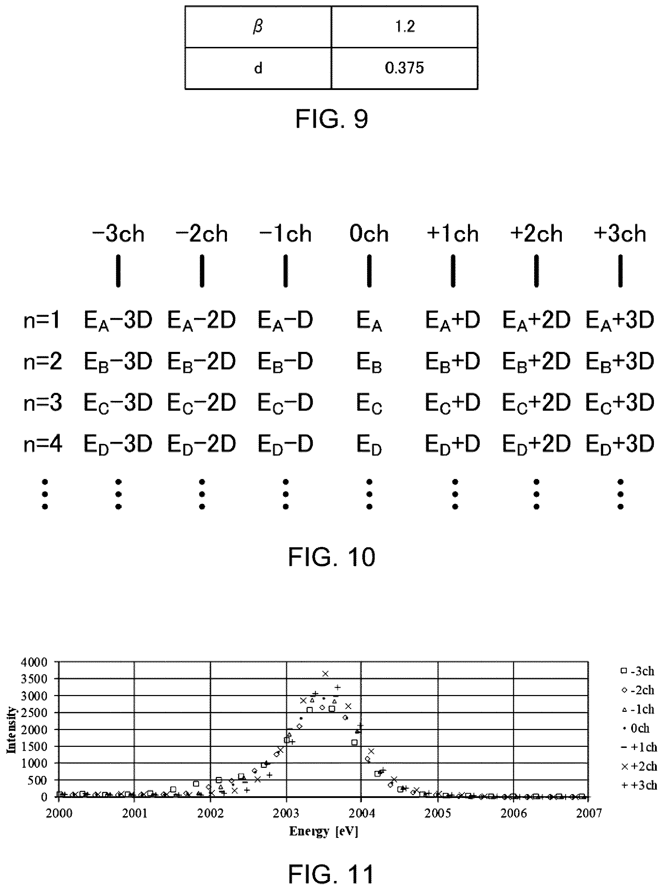

For example, the lower limit $\beta$ and the ratio d are determined by preparing a numerical table. FIG. 9 shows one example of a table of $\beta$ and d. The table of FIG. 9 is used when a qualitative analysis is performed in the CRR mode under the condition $\gamma = 0.2$.

In the table shown in FIG. 9, the values of $\beta$ and d are set such that variations in the peak intensity of a spectrum are on the order of 5%. Where a quantitative analysis is performed, it is desired to reduce the set values of $\beta$ and d such that variations in the peak intensity are nearly equal to or less than the SN ratio. A measurement can be made with incremental energy step $\Delta E_1$ complying with the purpose of the measurement by varying the value of $\beta$ and d according to the purpose of measurement in this way.

A plurality of tables for setting $\beta$ and d are prepared according to the purpose of measurement, energy resolution, and measurement mode (either the CAE mode or the CRR mode). The processor 60 refers to the tables according to the purpose of measurement, energy resolution, and measurement mode, sets the values of $\beta$ and d, and calculates the incremental energy step $\Delta E_1$.

2.3. Measurement

In the electron spectrometer 100, the electron beam emitted from the electron gun 12 is focused by the electron lenses 14 and made to hit the sample S. In response, Auger electrons, secondary electrons, and others are emitted from the sample S.

Auger electrons emitted from the sample S enter the input lens assembly 32, are decelerated by the electrostatic lenses 33, and enter the electrostatic hemispherical analyzer 34. The incident Auger electrons are dispersed in energy by the hemispherical analyzer 34 at the plane of energy dispersion of the hemispherical analyzer 34 according to the kinetic energies in the direction of energy dispersion A.

The Auger electrons dispersed according to energy are detected by the 7 channeltrons 42 arrayed in the direction of dispersion of energy A. The detected electrons are counted by the counter-computer 54 for each channeltron 42 and the resulting count is sent to the processor 60.

When a spectrum is collected, electrons dispersed in energy are detected by the 7 channeltrons 42 while sweeping the energy in incremental energy steps of $\Delta E_1$ within the electron analyzer 30, and this process is repeated.

FIG. 10 shows the measurement energies for the channeltrons 42 of the detector 40. For example, in the first (n = 1) measurement, electrons with energy $E_A$ are detected in the 0 ch (channel). Electrons with energy $E_A - D$ are detected in the -1 ch. Electrons with energy $E_A - 2D$ are detected in the -2 ch. Electrons with energy $E_A - 3D$ are detected in the -3 ch. Electrons with energy $E_A + D$ are detected in the +1 ch. Electrons with energy $E_A + 2D$ are detected in the +2 ch. Electrons with energy $E_A + 3D$ are detected in the +3 ch. In the second (n = 2) measurement, electrons with energy $E_B$ are detected in the 0 ch. Electrons with energy $E_B - D$ are detected in the -1 ch. Electrons with energy $E_B -$

2D are detected in the -2 ch. Electrons with energy $E_B - 3D$ are detected in the -3 ch. Electrons with energy $E_B + D$ are detected in the +1 ch. Electrons with energy $E_B + 2D$ are detected in the +2 ch. Electrons with energy $E_B + 3D$ are detected in the +3 ch. The difference between the energies $E_B$ and $E_A$ is the incremental energy step $\Delta E_1$. That is, $E_B = E_A + \Delta E_1$. In the third ($n = 3$) measurement, the energy Ec detected in the 0 ch satisfies the relationship: $Ec = E_B + \Delta E_1 = E_A + \Delta 2E_1$. In the fourth ($n = 4$) measurement, the energy $E_D$ detected in the 0 ch satisfies the relationship: $E_D = E_C + \Delta E_1 = E_A + \Delta 3E_1$.

In this way, a measurement is repetitively performed while sweeping the energy in incremental energy steps of $\Delta E_1$ within the electron analyzer 30, and a spectrum is collected for each channel. The electron spectrometer 100 can produce 7 spectra in a corresponding manner to the 7 channels.

FIG. 11 shows the 7 spectra and has been obtained by plotting the measurement energy and the measured intensity for each channel. In the electron spectrometer 100, the measurement energy is swept in incremental energy steps of $\Delta E_1$ and, therefore, each spectrum consists of discrete values. One incremental energy step of one spectrum, i.e., the difference D in measurement energy between adjacent measuring points is $\Delta E_1$. An example in the CAE mode has been described. In the CRR mode, the difference D in measurement energy between channels and one incremental energy step $\Delta E_1$ are dependent on the measurement energy.

2.4. Setting of Incremental Energy Step $\Delta E_2$

In the electron spectrometer 100, incremental energy step $\Delta E_2$ used during generation of a spectrum is set regardless of the incremental energy step $\Delta E_1$ used during measurement. Consequently, optimum incremental energy steps can be set during measurement and during generation of a spectrum.

In the electron spectrometer 100, the incremental energy step $\Delta E_2$ is set smaller than the incremental energy step $\Delta E_1$ ($\Delta E_2 < \Delta E_1$). For example, the incremental energy step $\Delta E_2$ is approximately greater than 1/10 and less than 1/2 of the incremental energy step $\Delta E_1$. That is, the incremental energy step $\Delta E_2$ has a value satisfying the relationship: $(1/10) \times \Delta E_1 \leq \Delta E_2 \leq (1/2) \times \Delta E_1$. A good balance can be achieved between the interpolation error and the amount of data by setting the incremental energy step $\Delta E_2$ within this range.

Also, in the CRR mode, the incremental energy step $\Delta E_1$ varies according to the measurement energy. Even if a measurement is made in the CRR mode, the incremental energy step $\Delta E_2$ can be made constant irrespective of the measurement energy.

2.5. Interpolation

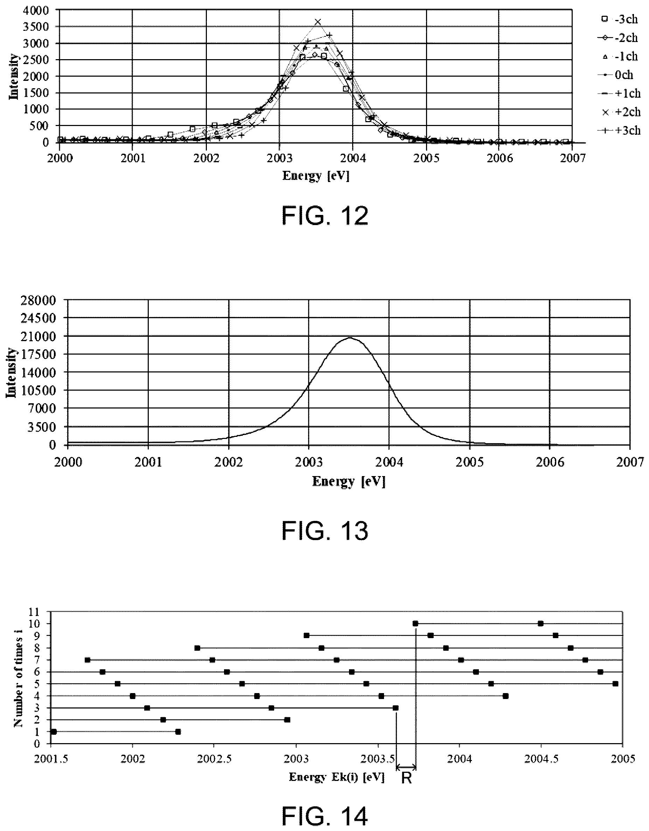

FIG. 12 illustrates processing for interpolating points of measurement in each of the seven spectra. In each of the 7 spectra, points of measurement present between actually measured points are interpolated computationally. In the example shown in FIG. 12, linear interpolation is effected by connecting the actually measured points by straight lines. There is no restriction on the method of interpolating points of measurement. Points of measurement may also be interpolated using a method other than linear interpolation such as spline interpolation. The incremental energy step of each spectrum can be transformed from $\Delta E_1$ into $\Delta E_2$ through linear interpolation. In each spectrum shown in FIG. 12, because the points of measurement are connected continuously by linear interpolation, the incremental energy step $\Delta E_2$ = 0.

2.6. Accumulating Operation

FIG. 13 is a graph showing a result of an operation for accumulating the 7 spectra for which the points of measurement have been linearly interpolated. As shown, by accumulating the seven spectra for which the points of measurement have been linearly interpolated, one multispectral chart can be generated.

As shown in FIG. 11, the channeltrons 42 are nonuniform in detection sensitivity. The effects of variations in detection sensitivity can be reduced by accumulating the 7 spectra for which the points of measurement have been linearly interpolated as shown in FIG. 13. Therefore, in the electron spectrometer 100, it is not needed to correct the variations in detection sensitivity among the channeltrons 42.

In the foregoing description, the incremental energy step $\Delta E_2$ is reduced down to zero ($\Delta E_2$ = 0) by linearly interpolating and continuously connecting points of measurement. A multispectral chart can be generated by a similar technique irrespective of what value the incremental energy step $\Delta E_2$ assumes, if incremental energy step $\Delta E_2$ = 0 can be computed. For example, a multispectral chart with the set incremental energy step $\Delta E_2$ may be generated by extracting points of measurement from the spectrum of FIG. 13 according to the incremental energy step $\Delta E_2$. Furthermore, a multispectral chart with the set incremental energy step $\Delta E_2$ may be generated by extracting points of measurement from each of the seven spectra for which points of measurement have been interpolated so as to achieve the incremental energy step $\Delta E_2$ and then accumulating the seven spectra for which the points of measurement have been extracted.

A method of generating a single multispectral chart by accumulating the seven spectra for which the points of measurement have been interpolated has been described. Alternatively, a single multispectral chart may be generated by averaging seven spectra for which points of measurements have been interpolated.

2.7. Interpolation Calculation and Ratio d

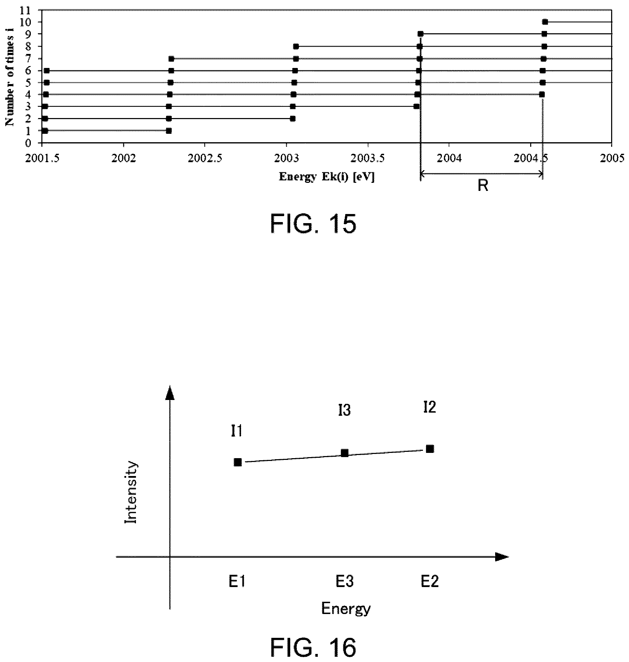

When the seven spectra shown in FIG. 12 are cumulatively summed, it is desirable that the measurement energies for the respective spectra are not coincident. FIG. 14 shows a case where the measurement energies for the respective ones of 7 spectra are not coincident. FIG. 15 shows a case where the measurement energies for the respective ones of 7 spectra are coincident. In the case of FIG. 15 where the spectra are coincident in measurement energy, there is a wide energy range R where there are no actually measured points but there are only interpolated points of measurement. On the other hand, in the case of FIG. 14 where the spectra are not coincident in measurement energy, actually measured points are scattered over a wide range and so the energy range R consisting only of interpolated points of measurement can be narrowed.

The intensities of the interpolated points of measurement are different in SN ratio from the intensities of actually measured points. FIG. 16 illustrates the SN ratio at the actually measured points and the SN ratio at the interpolated points of measurement.

Where the spectral intensities $I_1$ at the actually measured points follow a Poisson distribution, the SN ratio of the intensities $I_1$ is $I_1^{1/2}$. Similarly, the SN ratio of the intensities $I_2$ is $I_2^{1/2}$, Assuming that $\alpha = (E_3 - E_1) / (E_2 - E_1)$, calculation of $I_3$ through linear interpolation results in: $I_3 = (1 - \alpha) \cdot I_1 + \alpha \cdot I_2$. Therefore, the SN ratio of the intensity $I_3$ is given by

$$\frac{(1 - \alpha) \cdot I_1 + \alpha \cdot I_2}{\sqrt{(1 - \alpha)^2 \cdot I_1 + \alpha^2 \cdot I_2}}$$

In interpolation, the relationship, $0 \leq \alpha \leq 1$, holds. The SN ratio of the spectral intensities at the interpolated points of measurement is equal to or higher than the SN ratio of intensity values assumed when a Poisson distribution is obeyed. In this way, interpolation varies the SN ratio. Therefore, the incremental energy step $\Delta E_1$ is so set that the effect of the variation of the SN ratio is not concentrated on a certain range of measurement energy.

If the ratio d is varied, then the incremental energy step $\Delta E_1$ also varies. Accordingly, the ratio d is so set that the measurement energies for the respective spectra are made noncoincident as much as possible. For example, the ratio d is set to a value smaller than unity. Where the ratio d = 1, i.e., the incremental energy step $\Delta E_1$ and the difference D in measurement energy between channels are equal, the measurement energies for the respective spectra are coincident with each other. In contrast, if the ratio d is set to a value smaller than unity, the number of coincident measurement energies can be reduced as compared to the case where the ratio d is 1. Consequently, the range of energies R consisting only of interpolated points of measurement can be made narrower.

As an example, let Nc be the number of the channeltrons 42. The ratio d is so set that the relationship, d = Nc / (Nc+ 1), holds. This can maintain the measurement energies for the respective spectra noncoincident. The ratio d is not restricted to the foregoing example. The ratio d may be set such that d = Nc / (Nc + $N_N$), where $N_N$ is a non-unity natural number that is not an integral submultiple of the number Nc.

3. Processing

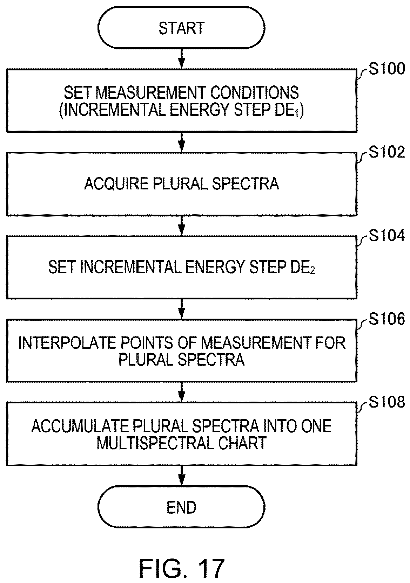

FIG. 17 is a flowchart illustrating one example of processing sequence performed by the processor 60. First, the processor 60 sets measurement conditions (S100). The processor 60 accepts the mode, starting energy, ending energy, and energy resolution specified by the user. The processor 60 sets the incremental energy step $\Delta E_1$ based on the specified energy resolution. For example, the processor 60 retrieves the values of the lower limit $\beta$ and the ratio d corresponding to the specified measurement mode and energy resolution from the table of $\beta$ and d which has been prepared for each measurement mode and each energy resolution. The processor 60 calculates the incremental energy step $\Delta E_1$ from above Eq. (1) in the CAE mode and from above Eq. (3) in the CRR mode. As described above, the incremental energy step $\Delta E_1$ is preferably so set that the measurement energies for the respective spectra are not coincident.

Then, the processor 60 sweeps the energy in incremental energy steps of $\Delta E_1$ within the electron analyzer 30. The electrons dispersed in energy by the analyzer 30 are detected by the 7 channeltrons 42 and thus 7 spectra are obtained (S102). The processor 60 causes, via the analyzer controller 52, the analyzer 30 to sweep the energy in incremental energy steps of $\Delta E_1$ set in the processing step S100. The processor 60 acquires the electron counts made by the channeltrons 42 from the counter-computer 54. Consequently, as shown in FIG. 11, seven spectra can be obtained.

Then, the processor 60 sets the incremental energy step $\Delta E_2$ to a value smaller than that of the incremental energy step $\Delta E_1$ ($\Delta E_2 < \Delta E_1$) optimally, for example, for display of generated spectra and analysis of the spectra (S104).

The processor 60 then performs interpolation operations for the 7 spectra to interpolate points of measurement (S106). For example, the interpolation operations are linear interpolation operations. Consequently, as shown in FIG. 12, each of the 7 spectra can have interpolated points of measurement.

Then, the processor 60 cumulatively sums the 7 spectra having the interpolated points of measurement, thus generating a single multispectral chart (S108) as shown in FIG. 13.

The processor 60 displays the generated multispectral chart on the display device and ends the processing sequence. Alternatively, the processor 60 may differentiate the generated multispectral chart and provide a display of the resulting differential spectral chart on the display device.

4. Incremental Energy Step $\Delta E_1$

As the incremental energy step $\Delta E_1$ during measurement increases, the measurement time can be shortened and the noise level can be reduced but the peaks of the spectrum are more distorted. In this way, there is a trade-off relationship between the noise level and the degree of distortion of the peaks of the spectrum.

The relationship between noise level and the degree of distortion of peaks of a spectrum which occurs when the ratio between the incremental energy steps $\Delta E_1$ and $\Delta E_2$ is varied is described below. It is herein assumed that there are 7 channeltrons.

(1) Relationship between Incremental Energy Step and Noise

In Auger electron spectroscopy, differential spectra are used to reduce the effects of the background. Letting $n$ be a natural number, a differential using $(2n + 1)$ points is given by

$$D(E) = \frac{\sum_{i=-n}^{n} n \cdot N(E + n \cdot \Delta E)}{2 \cdot \Delta E \cdot \sum_{i=1}^{n} i^2}$$

where N(E) is the electron intensity at energy E, D(E) is a derivative of the electron intensity at the energy E, and $\Delta E$ is an incremental energy step. If it is assumed that n = 3, then a differential is taken at seven points and the following equation results:

$$D(E) = \frac{\sum_{i=-3}^{3} n \cdot N(E + n \cdot \Delta E)}{28 \cdot \Delta E}$$

Letting $E_0$ be the measurement starting energy, the electron intensity is given by

$$N(E_0), N(E_0 + \Delta E), N(E_0 + 2 \cdot \Delta E), N(E_0 + 3 \cdot \Delta E), N(E_0 + 4 \cdot \Delta E), \dots$$

This is rearranged into the form:

$$N_0 = N(E_0)$$

$$N_1 = N(E_0 + \Delta E)$$

$$N_2 = N(E_0 + 2 \cdot \Delta E)$$

$$N_3 = N(E_0 + 3 \cdot \Delta E)$$

$$N_4 = N(E_0 + 4 \cdot \Delta E)$$

$$...$$

The above equation can be similarly represented in the following differential form:

$$D_0 = D(E_0)$$

$$D_1 = D(E_0 + \Delta E)$$

$$D_2 = D(E_0 + 2 \cdot \Delta E)$$

$$D_3 = D(E_0 + 3 \cdot \Delta E)$$

$$D_4 = D(E_0 + 4 \cdot \Delta E)$$

$$...$$

Using an arbitrary integer m, a differential of $N_m$ at seven points is given by

$$D_m = \frac{-3 \cdot N_{m-3} - 2 \cdot N_{m-2} - N_{m-1} + N_{m+1} + 2 \cdot N_{m+2} + 3 \cdot N_{m+3}}{28 \cdot \Delta E}$$

Since a spectral intensity obeys a Poisson distribution, the noise level $\sigma_m$ of $N_m$ is given by

$$\sigma_m = \sqrt{N_m}$$

$N_m$ is represented as the sum of the signal component $S_m$ and the noise component $\sigma_m$ and thus

$$N_m = S_m + \sigma_m$$

Consequently, the differential of $N_m$ at seven points is given by

$$D_m = D_{S_m} + D_{\sigma_m}$$

$$D_{S_m} = \frac{-3 \cdot S_{m-3} - 2 \cdot S_{m-2} - S_{m-1} + S_{m+1} + 2 \cdot S_{m+2} + 3 \cdot S_{m+3}}{28 \cdot \Delta E}$$

$$D_{\sigma_m} = \frac{-3 \cdot \sigma_{m-3} - 2 \cdot \sigma_{m-2} - \sigma_{m-1} + \sigma_{m+1} + 2 \cdot \sigma_{m+2} + 3 \cdot \sigma_{m+3}}{28 \cdot \Delta E}$$

where $D_{sm}$ is the signal component of $D_m$ and $D_{\sigma m}$ is the noise component of $D_m$.

It is assumed hereinafter that the signal components $S_m$ - 3 to $S_m$ +3 are almost equal in intensity. If the signal components $S_m$ - 3 to $S_m$ +3 are regarded as probability variables, then the noise components $\sigma_m$ - 3 to $\sigma_m$ + 3 can be regarded as nearly equal in dispersion.

In the following, the incremental energy step $\Delta E_1$ taken during measurement of spectra is referred to as the incremental measurement step. The incremental energy step $\Delta E_2$ taken during calculation of differentials using the Savitzky-Golay method is referred to as the incremental differential step.

First, the noise level is found under the conditions in which $\Delta E_1/ \Delta E_2 = 1$, i.e., the incremental measurement step and the incremental differential step are equal to each other.

The noise components of their respective measurement energies are independent of each other, i.e., their probability variables are independent of each other. Therefore, the noise component $\sigma_m$ of the intensity $N_m$ is given by

$$D_{\sigma_m} = \frac{-3 \cdot \sigma_{m-3} - 2 \cdot \sigma_{m-2} - \sigma_{m-1} + \sigma_{m+1} + 2 \cdot \sigma_{m+2} + 3 \cdot \sigma_{m+3}}{28 \cdot \Delta E}$$

$$= \frac{\sqrt{(-3 \cdot \sigma_m)^2 + (-2 \cdot \sigma_m)^2 + (-\sigma_m)^2 + (\sigma_m)^2 + (2 \cdot \sigma_m)^2 + (3 \cdot \sigma_m)^2}}{28 \cdot \Delta E}$$

$$= \frac{\sqrt{7}}{14 \cdot \Delta E} \sigma_m$$

$$\cong 0.189 \cdot \Delta E^{-1} \cdot \sigma_m$$

It is seen from the above equation that as the incremental energy step $\Delta E$ increases, the noise level decreases. However, because the incremental energy step for calculation of differentials is in proportion to the incremental energy step $\Delta E$, there is a trade-off relationship between the incremental energy step and the noise level during calculations of differentials.

Then, the noise level is found under the conditions in which $\Delta E_1/ \Delta E_2 = 2$, i.e., the incremental measurement step is twice the incremental differential step. When the incremental measurement step is twice as large as the incremental differential step, the incremental measurement step may be set to $2 \cdot \Delta E$, and the incremental differential step may be set to $\Delta E$.

In order to calculate differentials by the Savitzky-Golay method, the incremental measurement steps of $2 \cdot \Delta E$ of a spectrum are subjected to a step transform using a linear interpolation.

$$N_0 = N(E_0)$$

$$N_2 = N(E_0 + 2 \cdot \Delta E)$$

$$N_4 = N(E_0 + 4 \cdot \Delta E)$$

$$\cdots$$

The linear interpolation is represented as follows:

$$N_1 = \frac{1}{2} \cdot N(E_0) + \frac{1}{2} \cdot N(E_0 + 2 \cdot \Delta E)$$

$$N_3 = \frac{1}{2} \cdot N(E_0 + 2 \cdot \Delta E) + \frac{1}{2} \cdot N(E_0 + 4 \cdot \Delta E)$$

$$N_5 = \frac{1}{2} \cdot N(E_0 + 4 \cdot \Delta E) + \frac{1}{2} \cdot N(E_0 + 8 \cdot \Delta E)$$

$$...$$

At this time, the noise component $D_{\sigma_m}$ differs according to whether m is even or odd. When m is even (m modulo 2 = 0), the noise component $D_{\sigma_m}$ is given by

$$
\begin{aligned}
D_{\sigma m} &= \frac{-3 \cdot \left(\frac{1}{2} \cdot \sigma_{m-4} + \frac{1}{2} \cdot \sigma_{m-2}\right) - 2 \cdot \sigma_{m-2} - \left(\frac{1}{2} \cdot \sigma_{m-2} + \frac{1}{2} \cdot \sigma_m\right)}{28 \cdot \Delta E} \\
&\quad + \frac{+ \left(\frac{1}{2} \cdot \sigma_m + \frac{1}{2} \cdot \sigma_{m+2}\right) + 2 \cdot \sigma_{m+2} + 3 \cdot \left(\frac{1}{2} \cdot \sigma_{m+2} + \frac{1}{2} \cdot \sigma_{m+4}\right)}{28 \cdot \Delta E} \\
&= \frac{-3\sigma_{m-4} - 8 \cdot \sigma_{m-2} + 8 \cdot \sigma_{m+2} + 3 \cdot \sigma_{m+4}}{2 \cdot 28 \cdot \Delta E} \\
&= \frac{\sqrt{(-3 \cdot \sigma_m)^2 + (-8 \cdot \sigma_m)^2 + (-\sigma_m)^2 + (\sigma_m)^2 + (8 \cdot \sigma_m)^2 + (3 \cdot \sigma_m)^2}}{2 \cdot 28 \cdot \Delta E} \\
&= \frac{\sqrt{146}}{56 \cdot \Delta E} \sigma_m \\
&\cong 0.216 \cdot \Delta E^{-1} \cdot \sigma_m
\end{aligned}
$$

When m is odd (m modulo 2 = 1), the noise component $D_{\sigma_m}$ is given by

$$D_{\sigma m} = \frac{-3 \cdot \sigma_{m-3} - 2 \cdot \left(\frac{1}{2} \cdot \sigma_{m-3} + \frac{1}{2} \cdot \sigma_{m-1}\right) - \sigma_{m-1}}{28 \cdot \Delta E}$$

$$+ \frac{+\sigma_{m+1} + 2 \cdot \left(\frac{1}{2} \cdot \sigma_{m+1} + \frac{1}{2} \cdot \sigma_{m+3}\right) + 3 \cdot \sigma_{m+3}}{28 \cdot \Delta E}$$

$$= \frac{-4\sigma_{m-3} - 2 \cdot \sigma_{m-1} + 2 \cdot \sigma_{m+1} + 4 \cdot \sigma_{m+3}}{28 \cdot \Delta E}$$

$$= \frac{\sqrt{(-4 \cdot \sigma_m)^2 + (-2 \cdot \sigma_m)^2 + (2 \cdot \sigma_m)^2 + (4 \cdot \sigma_m)^2}}{28 \cdot \Delta E}$$

$$= \frac{\sqrt{10}}{14 \cdot \Delta E} \sigma_m$$

$$\cong 0.226 \cdot \Delta E^{-1} \cdot \sigma_m$$

When the incremental measurement step is M times as great as the incremental differential step, i.e., $\Delta E_1/ \Delta E_2$ = M, where M is a natural number, only the calculated noise level is given below.

Table 1

| M | $m$ modulo M | $D_{\sigma m}$ |
|---|---|---|
| 1 | 0 | $0.189 \cdot \Delta E^{-1} \cdot \sigma_m$ |
| 2 | 0 | $0.216 \cdot \Delta E^{-1} \cdot \sigma_m$ |
| 2 | 1 | $0.232 \cdot \Delta E^{-1} \cdot \sigma_m$ |
| 3 | 0 | $0.236 \cdot \Delta E^{-1} \cdot \sigma_m$ |
| 3 | 1 | $0.223 \cdot \Delta E^{-1} \cdot \sigma_m$ |
| 3 | 2 | $0.223 \cdot \Delta E^{-1} \cdot \sigma_m$ |
| 4 | 0 | $0.177 \cdot \Delta E^{-1} \cdot \sigma_m$ |
| 4 | 1 | $0.220 \cdot \Delta E^{-1} \cdot \sigma_m$ |
| 4 | 2 | $0.243 \cdot \Delta E^{-1} \cdot \sigma_m$ |
| 5 | 0 | $0.141 \cdot \Delta E^{-1} \cdot \sigma_m$ |
| 5 | 1 | $0.176 \cdot \Delta E^{-1} \cdot \sigma_m$ |
| 5 | 2 | $0.239 \cdot \Delta E^{-1} \cdot \sigma_m$ |
| 6 | 0 | $0.118 \cdot \Delta E^{-1} \cdot \sigma_m$ |
| 6 | 1 | $0.147 \cdot \Delta E^{-1} \cdot \sigma_m$ |
| 6 | 2 | $0.219 \cdot \Delta E^{-1} \cdot \sigma_m$ |
| 6 | 3 | $0.236 \cdot \Delta E^{-1} \cdot \sigma_m$ |
| 7 | 0 | $0.101 \cdot \Delta E^{-1} \cdot \sigma_m$ |
| 7 | 1 | $0.126 \cdot \Delta E^{-1} \cdot \sigma_m$ |
| 7 | 2 | $0.171 \cdot \Delta E^{-1} \cdot \sigma_m$ |
| 7 | 3 | $0.202 \cdot \Delta E^{-1} \cdot \sigma_m$ |
| 8 | 0 | $0.088 \cdot \Delta E^{-1} \cdot \sigma_m$ |

(continued)

| M | _m_ modulo M | $D_{\sigma_m}$ |
|---|---|---|
| 8 | 1 | $0.110 \cdot \Delta E^{-1} \cdot \sigma_m$ |
| 8 | 2 | $0.149 \cdot \Delta E^{-1} \cdot \sigma_m$ |
| 8 | 3 | $0.177 \cdot \Delta E^{-1} \cdot \sigma_m$ |
| 8 | 4 | $0.177 \cdot \Delta E^{-1} \cdot \sigma_m$ |

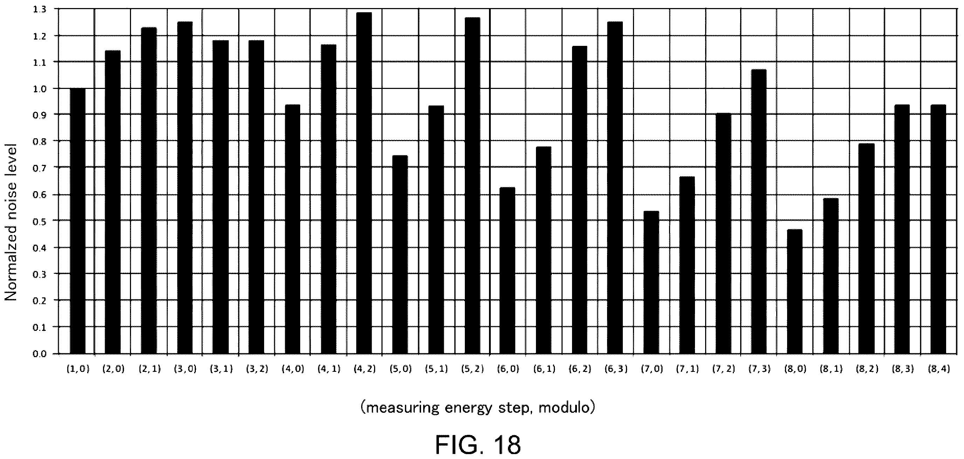

FIG. 18 is a graph showing the noise level calculated when the incremental measurement step is M times the incremental differential step. In the graph of FIG. 18, the noise level has been normalized under the condition in which the noise component $D_{\sigma_m}$ is 1 at M = 1.

According to the Table and graph showing the calculated noise level, since the incremental measurement steps are different from each other, the measurement times are also different from each other. A normalization is done such that all the measurement times are brought to equal to the measurement time at M = 1 by lengthening the measurement times for their respective measurement energies as the incremental measurement time is increased.

When the incremental measurement step is increased to M times, the measurement time also increases M times, and the spectral intensity is also increased M times. Consequently, the SN ratio is improved by a factor of $M^{1/2}$.

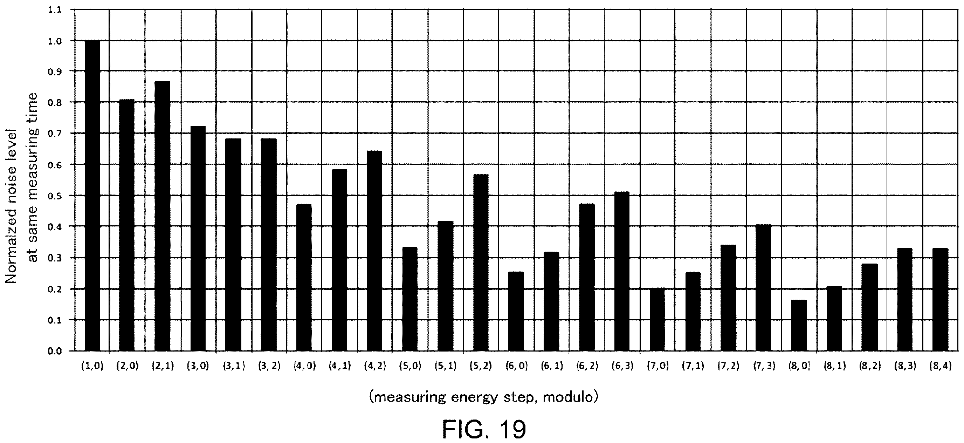

FIG. 19 is a graph showing the noise component $D_{\sigma_m}$ normalized with the measurement time at M = 1. It can be seen from this graph that as the magnitude of each incremental measurement step is increased, the noise component decreases. For example, if the magnitude of each incremental measurement step is increased four times, the noise component is roughly halved.

If the incremental measurement steps and the incremental differential steps are different in magnitude, differentials are computed after interpolation of N (E). At this time, energies used during measurement and energies used during differentiation are shifted by an amount between 0 and $\Delta E$.

Electron counts $N_0$, $N_1$, $N_2$, ... made when energies used during measurement are $E_0$, $E_0 + \Delta E$, $E_0 + 2 \cdot \Delta E$, ... are given by

$$N_0 = N(E_0)$$

$$N_1 = N(E_0 + \Delta E)$$

$$N_2 = N(E_0 + 2 \cdot \Delta E)$$

$$N_3 = N(E_0 + 3 \cdot \Delta E)$$

$$N_4 = N(E_0 + 4 \cdot \Delta E)$$

$$...$$

If an energy used during differentiation is shifted by an amount equal to $(1/2) \cdot \Delta E$, an interpolation is performed as follows:

$$N_{1.5} = \frac{N(E_0)}{2} + \frac{N(E_0 + \Delta E)}{2}$$

$$N_{2.5} = \frac{N(E_0 + \Delta E)}{2} + \frac{N(E_0 + 2 \cdot \Delta E)}{2}$$

$$N_{3.5} = \frac{N(E_0 + 2 \cdot \Delta E)}{2} + \frac{N(E_0 + 3 \cdot \Delta E)}{2}$$

$$N_{4.5} = \frac{N(E_0 + 3 \cdot \Delta E)}{2} + \frac{N(E_0 + 4 \cdot \Delta E)}{2}$$

$$N_{5.5} = \frac{N(E_0 + 4 \cdot \Delta E)}{2} + \frac{N(E_0 + 5 \cdot \Delta E)}{2}$$

$$...$$

If the energy is shifted by an amount equal to $(f_n / f_d) \cdot \Delta E$, an interpolation is performed using the following calculational formula:

$$N_{m+\frac{f_n}{f_d}} = \frac{f_d - f_n}{f_d} \cdot N(E_0 + m \cdot \Delta E) + \frac{f_n}{f_d} \cdot N(E_0 + (m + 1) \cdot \Delta E)$$

If the energy used during measurement is shifted, the independent component and the dependent component of the noise component vary between successive incremental energy steps. Therefore, the noise component $D_{\sigma m}$ used during differentiation also varies.

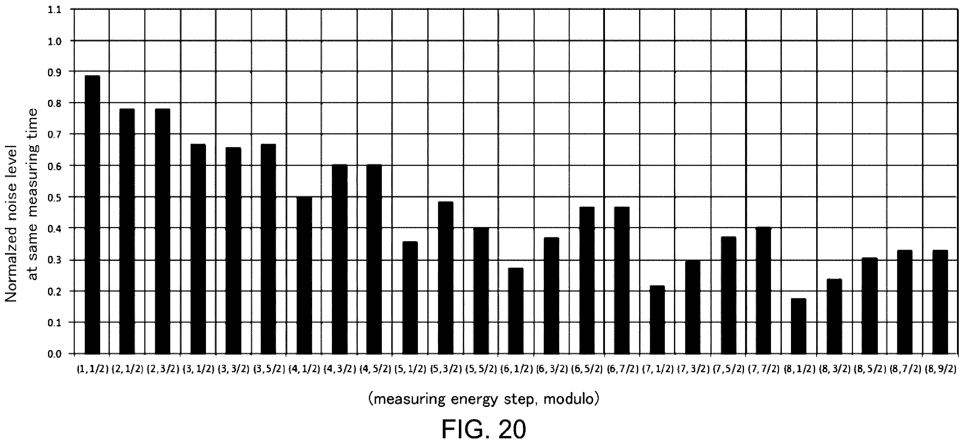

FIG. 20 shows the noise component $D_{\sigma m}$ normalized with the measurement time at M = 1. The noise component $D_{\sigma m}$ has been calculated after shifting the energy used during differential by an amount equal to $(1/2) \cdot \Delta E$.

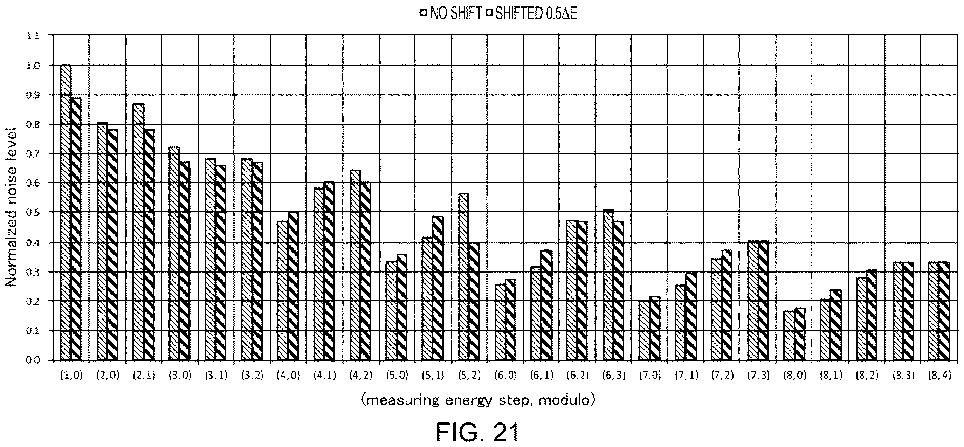

FIG. 21 is a graph comparing two cases in one of which the amount of energy shift during differential is zero. In the other case, the amount is $(1/2) \cdot \Delta E$. The left bar in each item shows the case where the amount of shift is zero. The right bar shows the case where the amount is $(1/2) \cdot \Delta E$.

It is seen that as the factor M is increased, the noise level decreases irrespective of whether or not the energy used during differential is shifted. Furthermore, if an interpolation is effected after the energy used during differentiation is shifted, the amount of variation of the noise level is only tens of percent and does not vary twofold or more.

This feature is encountered when the amount of shift takes any value between 0 and $\Delta E$ as well as when the amount of shift is zero and when the amount is $(1/2) \cdot \Delta E$.

With respect to a spectrum derived by an electron spectrometer, signals of multiple channels are accumulated into a single spectral chart. Since electron energies simultaneously detected by a multi-channel detector are different, the energies of the multi-channel signals are converted and the resulting signal intensities are computed by interpolation.

Regarding the noise component $D_{\sigma m}$, an average of m modulo M for all values of the factor M is calculated. Furthermore, regarding the noise component $D_{\sigma m}$, an average is computed for the case where the amount of shift is zero for all the values of M. In addition, an average is calculated for the case where the amount of shift is $(1/2) \cdot \Delta E$.

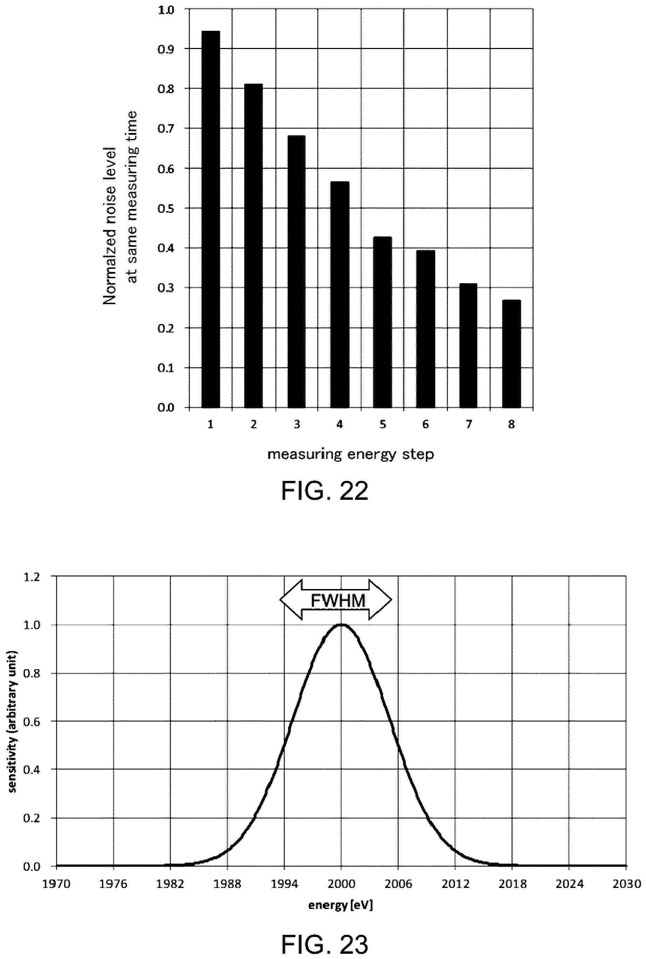

FIG. 22 is a graph showing the computed average of the noise component $D_{\sigma m}$. In this graph, the noise level occurring when the magnitude of each incremental measurement step is an integral multiple of that of each incremental differential step is schematically shown. Variations in the noise level occurring when the magnitude of the incremental measurement steps is increased can be estimated from the graph of FIG. 22.

Even if the incremental differential steps are different in magnitude from the incremental measurement steps, the noise level occurring at the time of generation of a spectrum has been already estimated roughly. It can be seen from the estimation results that as the magnitude of the incremental measurement steps increases, the noise level decreases.

(2) Incremental Energy Steps and Spectral Distortion

The relationship between the incremental measurement steps and distortion of spectral peak is next described. FIG. 23 illustrates a resolution function having a peak at 2,000 eV and $\Delta E$ (full width at half maximum) of 12 eV. For the sake of convenience, the resolution function is shown as a Gaussian distribution.

In order to detect the intensity that is half the maximum intensity of the peak in the neighborhood of 2,000 eV, it is necessary to hold down the incremental measurement steps to less than 12 eV ($\Delta E$). In qualitative analysis of Auger electron peaks, however, information about peak shapes is also utilized and so it is needed to make the incremental measurement steps much smaller than $\Delta E$.

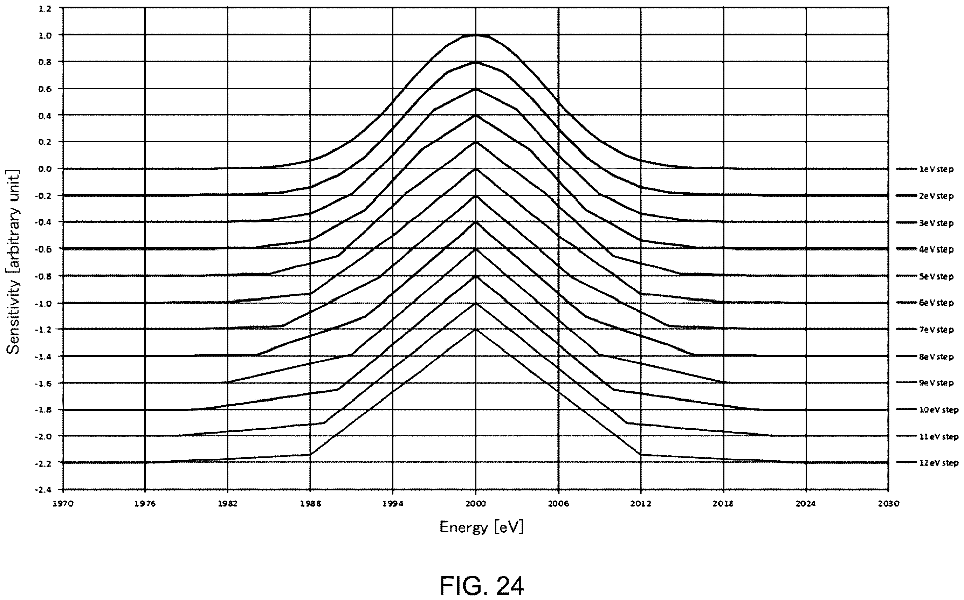

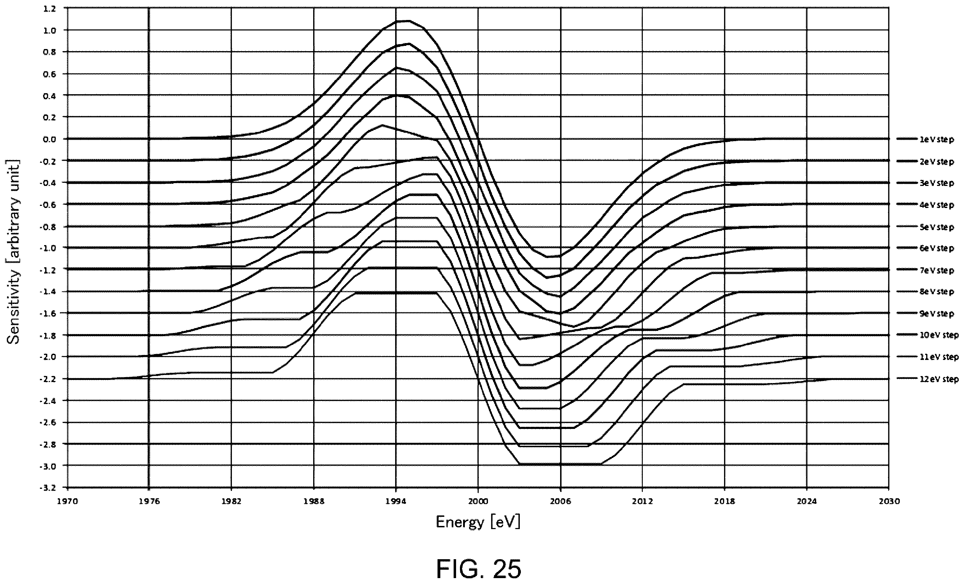

FIG. 24 illustrates a resolution function when the incremental measurement steps are varied. Energies not measured are found by interpolation. In the resolution function of FIG. 24, each incremental measurement step $\Delta E$ is varied from 1 eV to 12 eV in increments of 1 eV. FIG. 25 is a graph showing the result obtained by differentiating the resolution function at seven points when the incremental measurement steps are varied.

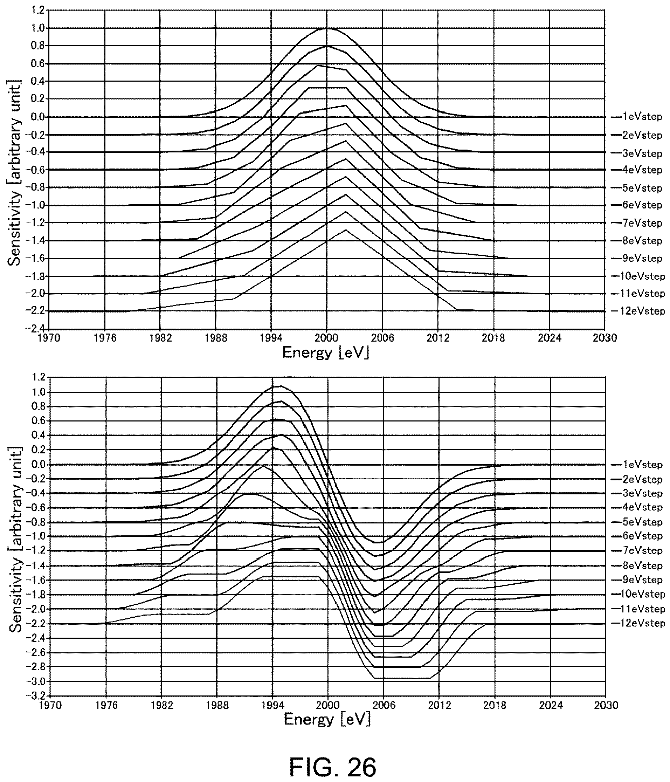

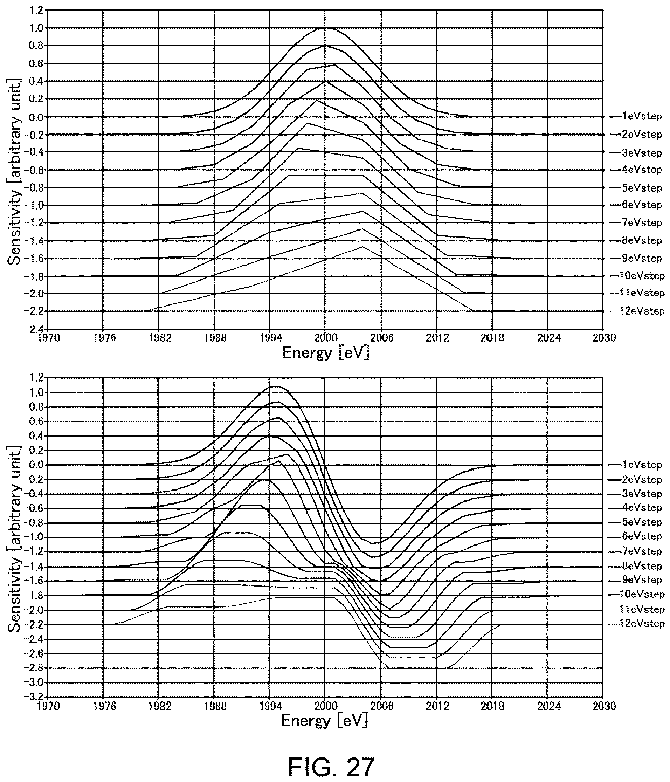

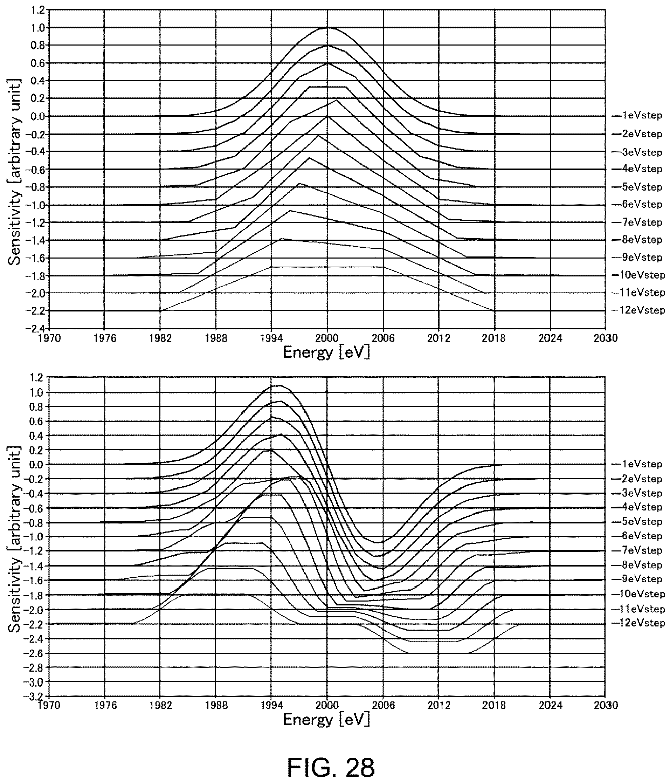

FIG. 26 is a graph showing the resolution function of FIG. 24 and differential results when the measurement starting energy of the resolution function is varied in increments of + 2 eV. FIG. 27 is a graph showing the resolution function of FIG. 24 and differential results when the measurement starting energy of the resolution function is varied in increments of + 4 eV. FIG. 28 is a graph showing the resolution function of FIG. 24 and differential results when the measurement starting energy of the resolution function is varied in increments of + 6 eV.

As shown in these FIGS. 25 to 28, it can be seen that as the magnitude of each incremental measurement step is increased, the differential waveform is more distorted. Especially, when each incremental measurement step exceeds the energy width (6 eV in the illustrated example) during differential calculation, the differential waveform is distorted greatly. If the measurement starting energy is varied, the differential waveform of the resolution function also varies.

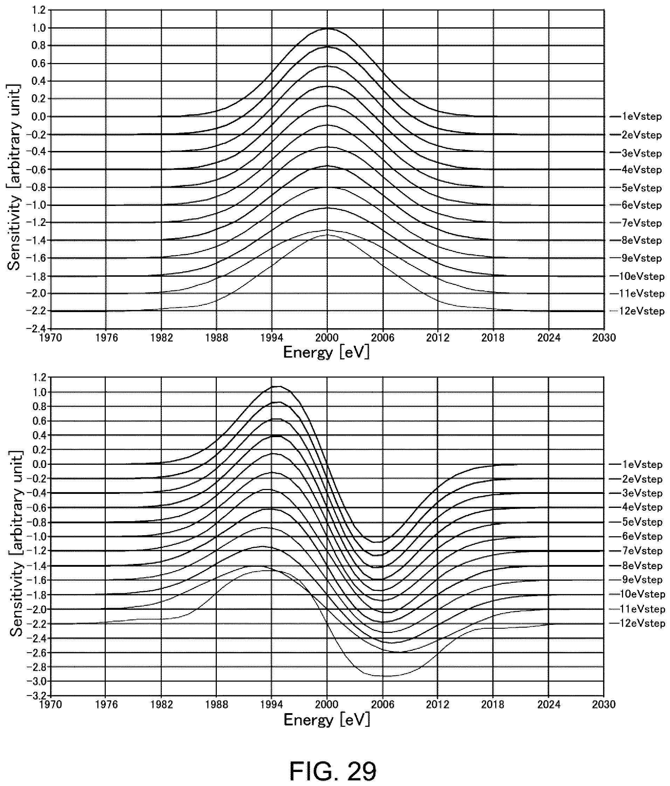

FIG. 29 shows a result of an operation of accumulating seven spectra. As shown, by accumulating the seven spectra, a smooth, continuous waveform arises. However, as the magnitude of each incremental measurement step is increased, the waveform is more distorted.

It is seen from the results shown in FIGS. 24-29 that peak waveforms do not distort when each incremental measurement step is less than 4 eV for the resolution function shown in FIG. 23.

5. Advantageous Effects

In the electron spectrometer 100, the processor 60 performs processing that involves: sweeping the energy in incremental steps of a first energy $\Delta E_1$ (measurement steps) in the electron analyzer 30, detecting with the channeltrons 42 electrons dispersed in energy by the analyzer 30, and obtaining a plurality of resulting first spectra; and interpolating points of measurements in each of the plurality of first spectra, and generating a multispectral chart in incremental steps of a second energy $\Delta E_2$ smaller than the first energy $\Delta E_1$ on the basis of the plurality of first spectra for which the points of measurement have been interpolated. Therefore, the electron spectrometer 100 can reduce the number of measurements, for example, as compared to the case where electrons are detected with a certain one channeltron. Consequently, the electron spectrometer 100 can reduce the measurement time taken for spectral collection.

In the electron spectrometer 100, the second energy $\Delta E_2$ of the incremental steps used during generation of spectra is different from the first energy $\Delta E_1$ of the incremental steps used during measurement. Therefore, in the electron spectrometer 100, optimum energy values of incremental steps can be set both during measurement and during generation of spectra. Consequently, in the electron spectrometer 100, if the incremental energy steps optimum for display of generated spectra or analysis of the spectra are different in magnitude from the incremental energy steps optimum for measurement of spectra, incremental energy steps optimum for them can be set.

In the electron spectrometer 100, the processor 60 creates a second spectrum or spectral chart by accumulating or averaging the plurality of first spectra for which the points of measurement have been interpolated. In this way, the effects of variations in the detection sensitivity can be reduced. Accordingly, in the electron spectrometer 100, the detection sensitivities of the channeltrons 42 do not need to be corrected.

In the electron spectrometer 100, the processor 60 performs an operation for accepting a specified energy resolution and an operation for setting incremental energy steps of $\Delta E_1$ on the basis of the energy resolution. Therefore, the electron spectrometer 100 makes it unnecessary for the user to set the incremental energy steps of $\Delta E_1$.

In the electron spectrometer 100, the processor 60 sets the ratio d of the incremental energy steps of $\Delta E_1$ to the difference in energy between the adjacent channeltrons 42 on the basis of the energy resolution and sets the incremental energy steps of $\Delta E_1$ based on the ratio d. Consequently, the incremental energy steps of $\Delta E_1$ can be set easily.

In the electron spectrometer 100, the processor 60 sets the magnitude of each incremental energy step $\Delta E_1$

such that the measurement energies for the respective first spectra are not coincident. Consequently, the energy range R consisting only of the interpolated points of measurement as shown in FIGS. 14 and 15 can be narrowed.

In the electron spectrometer 100, the processor 60 sets the ratio d at a value smaller than unity. As a result, the number of coincident measurement energies in each of the plurality of first spectra can be reduced as compared to the case where the ratio d is 1. This can narrow down the energy range R consisting only of the interpolated points of measurement as shown in FIGS. 14 and 15.

An analytical method using the electron spectrometer 100 comprises the steps of: sweeping the energy in first incremental steps of $\Delta E_1$ in the electron analyzer 30, causing electrons to be dispersed in energy with the analyzer 30, detecting the dispersed electrons with the channeltrons 42, and obtaining a plurality of first spectra; interpolating points of measurement in each of the plurality of first spectra; and generating a spectral chart in second incremental steps of $\Delta E_2$ smaller than $\Delta E_1$ on the basis of the plurality of first spectra for which the points of measurement have been interpolated. With this analytical method, the number of measurements can be reduced, for example, as compared to the case where electrons are detected with a certain one channeltron. Therefore, with the analytical method using the electron spectrometer 100, the measurement time taken for spectral collection can be reduced.

In the foregoing embodiment, an Auger electron spectrometer has been described as an electron spectrometer. Note that the primary probe directed at the sample to illuminate it is not restricted to an electron probe. Rather any probe means can be used as long as it can cause emission of electrons from a sample. For example, the primary probe may be an X-ray probe. That is, the electron spectrometer associated with the present invention may be an X-ray photoelectron spectrometer.

It is to be understood that the present invention is not restricted to the foregoing embodiments and that the invention can be practiced in variously varied forms. For example, the invention embraces configurations which are substantially identical to the configurations described in the embodiments. What are meant by the substantially identical configurations are configurations which are identical in functions and method, for example. Furthermore, the present invention embraces configurations which are similar to the configurations described in the above embodiments except that nonessential portions have been replaced. Further, the present invention embraces configurations similar to the configurations of the above embodiments except that well-known techniques have been added.

**Claims**

1. An electron spectrometer comprising:

   an electron analyzer for providing energy dispersion of electrons emitted from a sample;
   a detector having a plurality of detection elements juxtaposed and arranged in the direction of energy dispersion of the electrons which have been dispersed in energy by the analyzer; and
   a processor operating (i) to sweep a measurement energy in first incremental energy steps within the analyzer, to cause the electrons dispersed in energy by the analyzer to be detected by the plurality of detection elements, and to obtain a plurality of resulting first spectra; (ii) to interpolate points of measurement in each of the plurality of first spectra; and (iii) to generate a spectral chart in second incremental energy steps smaller than the first incremental energy steps on the basis of the plurality of first spectra for which the points of measurement have been interpolated.

2. An electron spectrometer as set forth in claim 1, wherein said processor generates said spectral chart by accumulating or averaging said plurality of first spectra for which the points of measurement have been interpolated.

3. An electron spectrometer as set forth in claim 1, wherein said processor operates to accept a specified energy resolution and to set said first incremental energy steps on the basis of the energy resolution.

4. An electron spectrometer as set forth in claim 3, wherein said processor operates to set the ratio between the difference in measurement energy between any adjacent two of said detection elements and the magnitude of each of said first incremental energy steps on the basis of said energy resolution and to set the magnitude of each of the first incremental energy steps on the basis of the ratio.

5. An electron spectrometer as set forth in claim 4, wherein said processor sets said ratio to a value smaller than unity.

6. An electron spectrometer as set forth in any one of claims 1 to 5, wherein said processor sets the magnitude of each of said first incremental energy steps such that the measurement energies for respective ones of said plurality of first spectra are not coincident.

7. An analytical method using an electron spectrometer including both an electron analyzer for providing energy dispersion of electrons emitted from a sample and a detector provided with a plurality of detection elements that are juxtaposed and arranged in the direction of energy dispersion of the electrons dispersed in energy by the analyzer, said analytical method comprising the steps of:

sweeping a measurement energy in first incremental energy steps within the analyzer so that electrons are dispersed in energy within the analyzer, detecting the dispersed electrons with the plurality of detection elements, and obtaining a plurality of resulting first spectra;
interpolating points of measurement in each of the plurality of first spectra; and
generating a spectral chart in second incremental energy steps smaller than the first incremental energy steps on the basis of the plurality of first spectra for which the points of measurement have been interpolated.

FIG. 1

FIG. 2

$E_0-3D$   $E_0-2D$   $E_0-D$   $E_0$   $E_0+D$   $E_0+2D$   $E_0+3D$

−3ch   −2ch   −1ch   0ch   +1ch   +2ch   +3ch

FIG. 3

FIG. 4

FIG. 5

FIG. 6

FIG. 7

FIG. 8

| $\beta$ | 1.2 |
|---|---|
| d | 0.375 |

FIG. 9

|  | −3ch | −2ch | −1ch | 0ch | +1ch | +2ch | +3ch |
|---|---|---|---|---|---|---|---|
|  | I | I | I | I | I | I | I |
| n=1 | $E_A$−3D | $E_A$−2D | $E_A$−D | $E_A$ | $E_A$+D | $E_A$+2D | $E_A$+3D |
| n=2 | $E_B$−3D | $E_B$−2D | $E_B$−D | $E_B$ | $E_B$+D | $E_B$+2D | $E_B$+3D |
| n=3 | $E_C$−3D | $E_C$−2D | $E_C$−D | $E_C$ | $E_C$+D | $E_C$+2D | $E_C$+3D |
| n=4 | $E_D$−3D | $E_D$−2D | $E_D$−D | $E_D$ | $E_D$+D | $E_D$+2D | $E_D$+3D |
| ⋮ | ⋮ | ⋮ | ⋮ | ⋮ | ⋮ | ⋮ | ⋮ |

FIG. 10

FIG. 11

FIG. 12

FIG. 13

FIG. 14

FIG. 15

FIG. 16

```
                    ┌─────────────────┐
                    │      START      │
                    └─────────────────┘
                             │
                             ▼
        ┌──────────────────────────────────────────┐  S100
        │       SET MEASUREMENT CONDITIONS          │
        │   (INCREMENTAL ENERGY STEP DE₁)           │
        └──────────────────────────────────────────┘
                             │
                             ▼
        ┌──────────────────────────────────────────┐  S102
        │          ACQUIRE PLURAL SPECTRA           │
        └──────────────────────────────────────────┘
                             │
                             ▼
        ┌──────────────────────────────────────────┐  S104
        │      SET INCREMENTAL ENERGY STEP DE₂      │
        └──────────────────────────────────────────┘
                             │
                             ▼
        ┌──────────────────────────────────────────┐  S106
        │  INTERPOLATE POINTS OF MEASUREMENT FOR    │
        │             PLURAL SPECTRA                │
        └──────────────────────────────────────────┘
                             │
                             ▼
        ┌──────────────────────────────────────────┐  S108
        │   ACCUMULATE PLURAL SPECTRA INTO ONE      │
        │          MULTISPECTRAL CHART              │
        └──────────────────────────────────────────┘
                             │
                             ▼
                    ┌─────────────────┐
                    │       END       │
                    └─────────────────┘
```

S100 — SET MEASUREMENT CONDITIONS (INCREMENTAL ENERGY STEP $DE_1$)

S102 — ACQUIRE PLURAL SPECTRA

S104 — SET INCREMENTAL ENERGY STEP $DE_2$

S106 — INTERPOLATE POINTS OF MEASUREMENT FOR PLURAL SPECTRA

S108 — ACCUMULATE PLURAL SPECTRA INTO ONE MULTISPECTRAL CHART

FIG. 17

FIG. 18

(measuring energy step, modulo)

FIG. 19

(measuring energy step, modulo)

FIG. 20

□ NO SHIFT □ SHIFTED 0.5ΔE

(measuring energy step, modulo)

FIG. 21

FIG. 22

FIG. 23

FIG. 24

FIG. 25

FIG. 26

FIG. 27

FIG. 28

FIG. 29

Europäisches
Patentamt

European
Patent Office

Office européen
des brevets

# EUROPEAN SEARCH REPORT

Application Number

**EP 23 17 4747**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 6 677571 B2 (JEOL LTD) 8 April 2020 (2020-04-08) * abstract * * figures 1-4, 14 * * paragraphs [0002], [0030] – [0117] * ----- | 1-7 | INV. H01J49/48 H01J49/02 H01J49/00 H01J37/244 G01N23/2273 G01N23/2276 |
| X | US 5 464 978 A (KUDO MASATO [JP] ET AL) 7 November 1995 (1995-11-07) * abstract * * figures 1, 2 * * column 1, lines 5-10 * * column 4, line 8 – column 10, line 12 * ----- | 1-7 | |

TECHNICAL FIELDS
SEARCHED (IPC)

H01J
G01N

The present search report has been drawn up for all claims

| Place of search | Date of completion of the search | Examiner |
|---|---|---|
| The Hague | 3 November 2023 | Dietsche, Rainer |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 17 4747

This annex lists the patent family members relating to the patent documents cited in the above-mentioned European search report.
The members are as contained in the European Patent Office EDP file on
The European Patent Office is in no way liable for these particulars which are merely given for the purpose of information.

03-11-2023

| Patent document cited in search report | | Publication date | Patent family member(s) | | Publication date |
|---|---|---|---|---|---|
| JP  6677571 | B2 | 08-04-2020 | JP | 6677571 B2 | 08-04-2020 |
| | | | JP | 2017204425 A | 16-11-2017 |
| US  5464978 | A | 07-11-1995 | JP | 3143279 B2 | 07-03-2001 |
| | | | JP | H0772102 A | 17-03-1995 |
| | | | US | 5464978 A | 07-11-1995 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001312994 A